# EUROPEAN PATENT SPECIFICATION

(11) **EP 3 879 930 B1**
(45) Date of publication and mention of the grant of the patent: **07.05.2025**
(21) Application number: 21162058.8
(22) Date of filing: 11.03.2021
(51) Int. Cl.: H05B 6/12, F24C 15/10

(54) **ELECTRIC RANGE AND AIR GUIDE INCLUDED IN THE SAME**
ELEKTRISCHE HERDPLATTE UND LUFTFÜHRUNG DARIN
APPAREIL ÉLECTRIQUE ET GUIDAGE D'AIR INCLUS DANS CELUI-CI

(30) Priority: 12.03.2020 KR 20200030923
(43) Date of publication of application: 15.09.2021
(60) Divisional application: 25158826.5
(73) Proprietor: LG Electronics Inc., Seoul 07336 (KR)
(72) Inventor: PARK, Jinwoo, Seoul 08592 (KR); CHO, Junghyeon, Seoul 08592 (KR); KIM, Seunghak, Seoul 08592 (KR)
(74) Representative: Ter Meer Steinmeister & Partner

(56) References cited:
- EP-A1- 3 334 248
- EP-A2- 1 936 283
- EP-A2- 2 498 574
- EP-A2- 2 531 003
- EP-A2- 2 679 913
- JP-A- 2007 294 474

## Description

### FIELD

Disclosed herein is an electric range, and more particularly, an electric range capable of guiding air output from an air blowing fan such that the air is delivered to an object to be cooled in a concentrated manner.

### BACKGROUND

Various types of cooking appliances are used to heat food at homes or restaurants. The cooking appliances include gas ranges using gas and electric ranges using electricity.

The electric ranges are classified as resistance heating-type electric ranges and induction heating-type electric ranges.

In a resistance heating method, electric current is supplied to a metallic resistance wire or a non-metallic heat generation element such as silicon carbide to generate heat, and the generated heat is radiated or conducted to heat an object to be heated (e.g., a cooking vessel such as a pot, a frying pan and the like).

In an induction heating method, high-frequency power is supplied to a coil to generate a magnetic field around the coil, and eddy current produced in the generated magnetic field is used to heat an object to be heated made of a metallic material.

Regarding basic theories of induction heating, when electric current is supplied to a working coil or a heating coil, heat is generated while an object to be heated is inductively heated, and the object to be heated is heated by the generated heat.

As a related art, an induction heat cooking apparatus (Korean Patent Publication No. 10-2017-0133937) is disclosed as a related art.

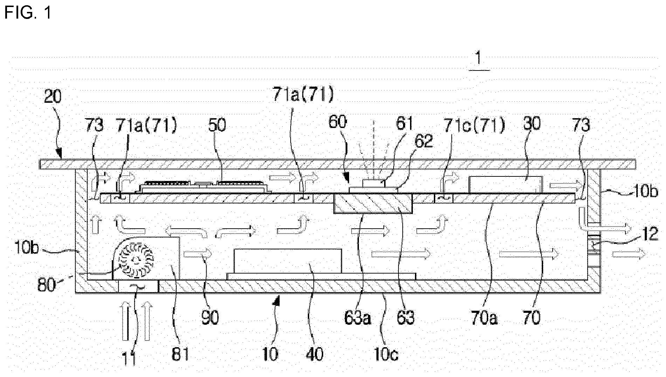

FIG. 1 is a view showing a shape of a related art.

FIG. 1 is presented in Korean Patent Publication No. 10-2015-0137756.

Referring to FIG. 1, a support plate 70 is provided with an induction coil part 50 in an upper portion thereof and a fan 80 in a lower portion thereof. Air discharged from the fan 80 cools a light emitting member 60 and other electronic components while circulating in a case 10 along a cooling path 90 provided under the support plate 70.

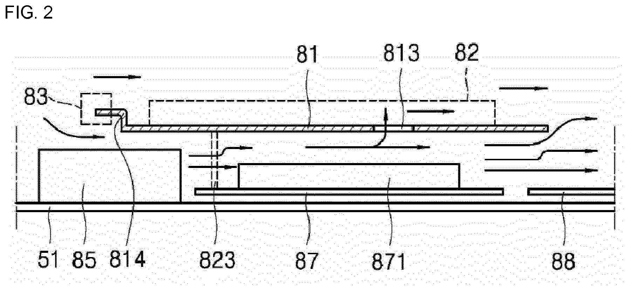

FIG. 2 is a view showing a shape of another related art.

FIG. 2 is disclosed in Korean Patent Publication No. 10-2018-0025011.

Referring to FIG. 2, a working coil 82 may be disposed on a middle plate 81, and a third fan 35 may be disposed below the middle plate 81. Air discharged from the third fan 85 cools a heat sink 871 below the middle plate 81 while flowing along a space under the middle plate 81.

In the related arts described with reference to FIGS. 1 and 2, air discharged from the fan is delivered in a diffused manner under the plate. Thus, in the related arts, air cannot be guide in a concentrated manner to an object to be cooled.
EP 2 498 574 A2 presents a carrier plate for a switch holder of a domestic appliance, assembly with such a carrier plate and induction hob with an assembly. The carrier plate has seats for positioning of a circuit carrier. A flow channel is formed by the walls of the carrier plate for the conduction of cooling air for cooling of electronic components of the circuit carrier. The flow channel is formed in the plate longitudinal side and formed with a receiving slot for the lateral insertion of an electronic component carrier. The carrier plate is made of plastic.

### SUMMARY

### Technical Problem

It is an object of the present invention to provide an electric range that may prevent air, output from an air blowing fan, from escaping out of an air guide.

It is another object of the present invention to provide an electric range that may guide air, output from an air blowing fan, to deliver the air to an object to be cooled in a concentrated manner.

It is another object of the present invention to provide an electric range that may help to improve cooling efficiency of a heat sink.

It is another object of the present invention to provide an electric range in which an air guide may be manufactured through single processing, thereby ensuring a reduction in manufacturing costs of the air guide.

It is another object of the present invention to provide an electric range in which an air guide may be easily coupled to a case.

Aspects are not limited to the above ones, and other aspects and advantages that are not mentioned above can be clearly understood from the following description and can be more clearly understood from the embodiments set forth herein.

### Technical Solution

One or more of these objects are solved by the features of the independent claim. In an electric range according to the present invention, an air guide may include a first member that prevents air, output from an air blowing fan, from flowing into a space between a lower surface of a case and a driving circuit, thereby blocking the air from escaping out of the air guide and helping to improve cooling efficiency of a heat sink as an object to be cooled.

In the electric range, the first member may be disposed at a slant, thereby delivering air to the heat sink in a concentrated manner.

In the electric range, the air guide may be disposed in a way that encircles at least a part of the driving circuit, thereby preventing air from escaping from between the air guide and the driving circuit.

In the electric range, the other end of the air guide may be disposed to connect to a through hole formed on the lower surface of the case, thereby effectively discharging air in the air guide out of the case.

In the electric range, a connecting portion having a bent shape may be formed at the other end of the air guide, thereby easily connecting the other end of the air guide to the through hole.

According to one aspect, an electric range comprises: a case having a first through hole and a second through hole on a lower surface thereof; a heating unit disposed in the case and configured to heat an object to be heated; a driving circuit disposed between the first through hole and the second through hole, and configured to drive the heating unit; an air blowing fan configured to output air supplied through the first through hole; and an air guide configured to guide air output from the air blowing fan to at least a part of the driving circuit and to discharge the air through the second through hole.

According to one aspect, an electric range comprises: a case; a heating unit disposed in the case and configured to heat an object to be heated; a driving circuit spaced a predetermined first distance apart from a lower surface of the case and configured to drive the heating unit; an air blowing fan disposed in contact with the lower surface of the case and configured to output air; and an air guide configured to guide air output from the air blowing fan to at least a part of the driving circuit. The air output from the air blowing fan may be supplied to one end of the air guide. A first member may be formed at one end of the air guide. The first member may be configured to prevent the air output from the air blowing fan from flowing into a space between the lower surface of the case and the driving circuit.

According to one aspect, an electric range comprises: a case having a first through hole and a second through hole, e.g. on a lower surface thereof; a heating unit disposed in the case and configured to heat an object to be heated; a driving circuit configured to drive the heating unit and disposed between the first through hole and the second through hole; an air blowing fan disposed in the case at the first through hole to introduce air supplied through the first through hole into the case; and an air guide disposed between the air blowing fan and the second through hole and configured to guide air output from the air blowing fan to at least a part of the driving circuit and then to the second through hole to discharge the air discharge therethrough.

According to one aspect, an air guide included in an electric range comprises: a housing having a hollow inside; and a first member formed on a lower side of one end of the housing, wherein air output from an air blowing fan of the electric range is supplied to one end of the housing, and air output from the air blowing fan is discharged through the other end of the housing, the other end of the housing having a curved shape. The first member may be configured to prevent the air output from the air blowing fan from flowing into a space between the lower surface of the case and the driving circuit in the case.

These aspects may include one or more of the following features:

The driving circuit may be spaced a predetermined first distance, i.e. in vertical direction, apart from the case, e.g. from a lower surface of the case. The driving circuit may be mounted on the case, e.g. on a lower surface of the case. Air output from the air blowing fan may be supplied to one end of the air guide. A first member may be formed at one end of the air guide. The first member may be configured to prevent the air output from the air blowing fan from flowing into a space between the lower surface of the case and the driving circuit.

The first member may be disposed between the air blowing fan and the driving circuit. One end of the first member may be disposed to contact the lower surface of the case. The other end of the first member may be disposed to contact an end of the driving circuit.

The first member may have an inclined shape, e.g. forming an angle with the lower surface of the case and/or with a horizontal plane. The first member may be formed at a lower end of one end of the air guide. Based on the inclined shape of the first member, air output from the air blowing fan, e.g. a lower portion of the air blowing fan, may be guided to at least a part of the driving circuit. That is, the first member may be configured to guide the air from the air blowing fan to an upper portion at least a part of the driving circuit.

A height, i.e. a vertical dimension or length, of the first member may correspond to the first distance.

A middle end (or middle portion) of the air guide may be disposed to encircle or surround or cover at least a part of the driving circuit. Both sides of the middle end of the air guide may be disposed in contact with the driving circuit, e.g. with an upper surface of a board of the driving circuit. The middle end may have a U-shaped cross-section, i.e. in a plane perpendicular to a connection line between the first through hole and the second through hole or perpendicular to the flow direction of air guided within the air guide.

The electric range may further comprise a heat sink disposed over at least a part of the driving circuit. The heat sink may be disposed inside the middle end of the air guide.

The other end of the air guide may be disposed in contact with or adjacent to and/or at least partially surrounding the second through hole. That is, the other end of the air guide may disposed adjacent to the second through hole to guide air flowing within the air guide to the second through hole to flow therethrough.

The other end of the air guide may have a curved shape or cross-section, e.g. in a plane perpendicular to the lower surface and parallel to a flow direction of the air flowing within the air guide. The other end of the air guide may have a shape configured to guide air flowing within the air guide to the second through hole to flow therethrough.

At least a portion of the other end, e.g. a lower portion of the other end, of the air guide may have a shape corresponding to a shape of the second through hole.

A first connecting portion may be formed at an end, e.g. at the other end, of the air guide. The first connecting portion may protrude to an outside of the second through hole to be couple to the other end of the air guide. That is, the first connecting portion may extend from the other end of the air guide in a direction away from the second through hole and/or from the middle end of the air guide.

The first connecting portion may have an extended portion extended downward, i.e. in vertical direction, from the other end of the air guide. The first connecting portion may further have a bent portion bent at, or extending at an angle from, the extended portion. The extended portion may be disposed in contact with an edge of the second through hole. The bent portion may be disposed under or below the lower surface of the case adjacent to the second through hole. The bent portion may extend through the second through hole to an outside of the case and/or may extend in parallel to the lower surface of the case.

At least one connecting portion may be formed extending laterally from the one end of the air guide that is adjacent to the air blowing fan. A second connecting portion and/or a third connecting portion may be formed on both sides of one end of the air guide. The second and/or third connection portion may have a coupling hole for coupling the air guide and the lower surface of the case.

The air guide may have an open lower side. That is, a side of the air guide facing the lower surface of the case is open. The end of the air guide adjacent to the air blowing fan may have an opening extending in a vertical plane. The end of the air guide adjacent to the second through hole may have an opening extending in a horizontal plane.

The electric range may be an electric resistance-type electric range or an induction heating-type electric range. Directional indication, such as height, heightwise or vertical direction, width, upper end, lower end etc. refer to an orientation when the electric range is in its operative state or position. In particular, a heightwise direction can also be referred to as vertical direction. Width may denote a dimension in the horizontal direction, in particular in a horizontal direction parallel to a (vertical) front surface of the case of the electric range which will be facing a user during operation. Thus, left end and right end may denote respectively a first lateral end and a second lateral end with respect to an operative state or position of the electric range. Likewise a front end may denote an end that is closer to a user when operating the electric range, while a rear end may denote an end that is farther from a user when operating the electric range.

### Advantageous Effect

According to the present disclosure, air output from an air bowing fan may be prevented from escaping out of an air guide.

According to the present disclosure, air output from the air blowing fan may be delivered to an object to be cooled in a concentrated manner.

According to the present disclosure, cooling efficiency of a heat sink may improve.

According to the present disclosure, manufacturing costs of the air guide may be reduced.

According to the present disclosure, the air guide may be readily assembled.

According to the present disclosure, since air output from the air blowing fan may flow from a front end to a rear end, to allow a user to touch an input interface without causing any inconvenience to the user.

Specific effects are described along with the above-described effects in the section of Detailed Description.

### BRIEF DESCRIPTION OF DRAWING

The accompanying drawings constitute a part of this specification, illustrate one or more embodiments of the present disclosure, and together with the specification, explain the present disclosure, wherein:
FIG. 1 and FIG. 2 are views relating to related arts;
FIG. 3 is a perspective view showing an induction heating device according to one embodiment;
FIGS. 4 to 7 are perspective views showing the induction heating device in FIG. 3 without some components;
FIG. 8 is a front perspective view showing an air guide according to one embodiment;
FIG. 9 is a rear perspective view showing an air guide according to one embodiment;
FIG. 10 is a lateral cross-sectional view showing an air guide according to one embodiment;
FIG. 11 is a view describing a concept of a shape in which an air blowing fan and an air guide are disposed in a case, according to one embodiment;
FIG. 12 is a front perspective view showing a driving circuit and an air guide disposed in a case, according to one embodiment;
FIG. 13 is a front cross-sectional view showing an air guide disposed in a case, according to one embodiment;
FIG. 14 is a view describing a concept in which air output from an air blowing fan flows into an air guide, according to one embodiment; and
FIG. 15 is a view showing a shape in which the other end of an air guide is coupled to a second through hole, according to one embodiment.

### DETAILED DESCRIPTION

The above-described aspects, features and advantages are specifically described hereunder with reference to the accompanying drawings such that one having ordinary skill in the art to which the present disclosure pertains can easily implement the technical idea of the disclosure. In the disclosure, detailed description of known technologies in relation to the disclosure is omitted if it is deemed to make the gist of the disclosure unnecessarily vague. Below, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components should not be limited by the terms. Certainly, a first component can be a second component unless stated to the contrary.

When one component is described as being "in an upper portion (or a lower portion)" of another component, or "on (or under)" another component, one component can be placed on the upper surface (or under the lower surface) of another component, and an additional component can be interposed between another component and one component on (or under) another component.

When one component is described as being "connected", "coupled", or "connected" to another component, one component can be directly connected, coupled or connected to another component; however, it is also to be understood that an additional component can be "interposed" between the two components, or the two components can be "connected", "coupled", or "connected" through an additional component.

Throughout the disclosure, each component can be provided as a single one or a plurality of ones, unless explicitly stated to the contrary.

The singular forms "a", "an" and "the" are intended to include the plural forms as well, unless explicitly indicated otherwise. It should be further understood that the terms "comprise" or "have," set forth herein, are not interpreted as necessarily including all the stated components or steps but can be interpreted as including some of the stated components or steps or can be interpreted as further including additional components or steps.

Throughout the disclosure, the terms "A and/or B" as used herein can denote A, B or A and B, and the terms "C to D" can denote C or greater and D or less, unless stated to the contrary.

Below, an electric range is described with reference to several embodiments.

The electric range in the disclosure may include an electric resistance-type electric range and an induction heating-type electric range (i.e., an induction heating device). For convenience, an induction heating device, provided with a working coil as a heating unit, is described as an example during description of the embodiments. However, embodiments are not limited to those set forth herein.

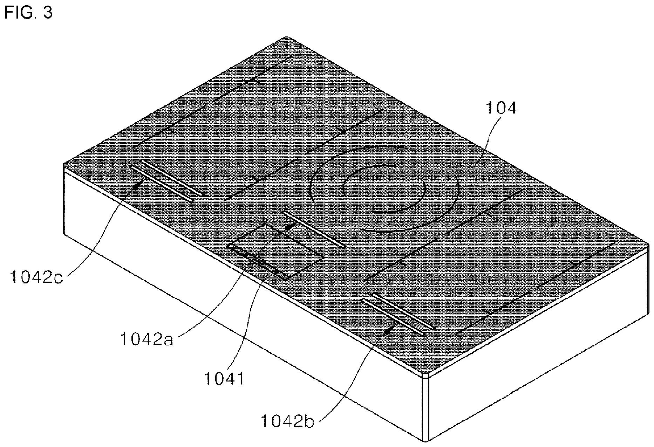

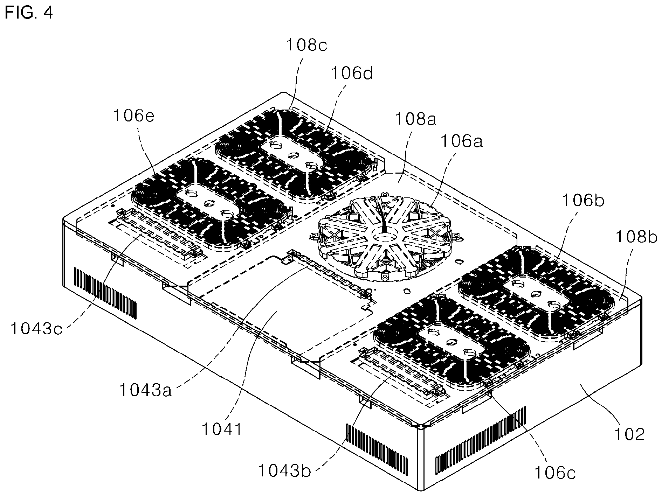

FIG. 3 is a perspective view showing an induction heating device 100 according to one embodiment. FIGS. 4 to 7 are perspective views showing the induction heating device 100 in FIG. 3 without some components.

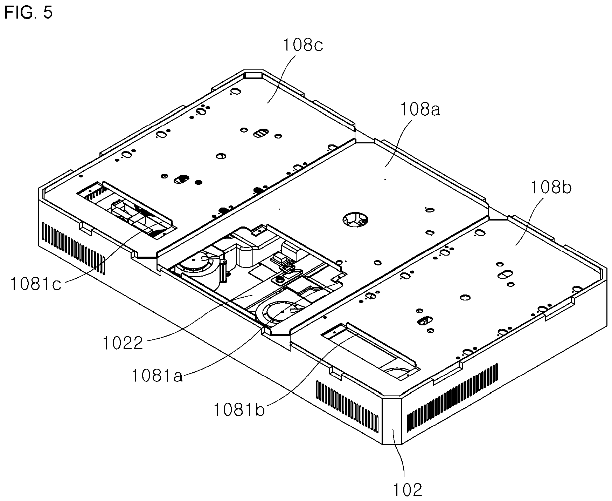

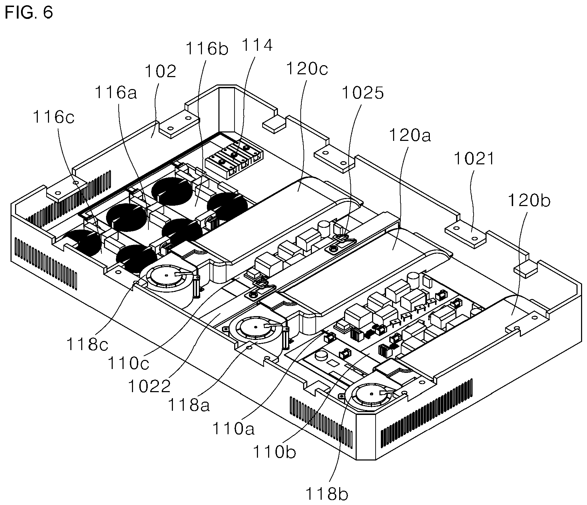

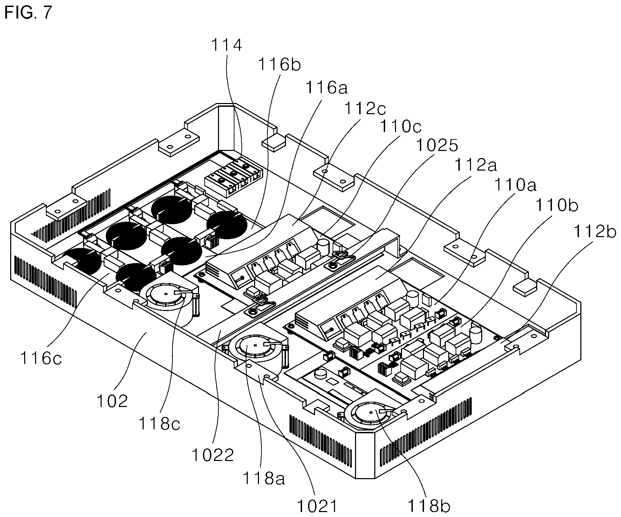

Specifically, FIG. 4 is a view showing the induction heating device 100 in FIG. 3 without a cover plate 104, FIG. 5 is a view showing the induction heating device 100 in FIG. 3 without a cover plate 104 and a working coil 106a, 106b, 106c, 106d, 106e, FIG. 6 is a view showing the induction heating device 100 in FIG. 3 without a cover plate 104, a working coil 106a, 106b, 106c, 106d, 106e, and a base plate 108a, 108b, 108c, and FIG. 7 is a view showing the induction heating device 100 in FIG. 3 without a cover plate 104, a working coil 106a, 106b, 106c, 106d, 106e, a base plate 108a, 108b, 108c and an air guide 120a, 120b, 120c.

Referring to FIGS. 3 to 7, the induction heating device 100 according to one embodiment may include a case 102, a cover plate 104, a working coil 106a, 106b, 106c, 106d, 106e, a base plate 108a, 108b, 108c, a driving circuit 110a, 110b, 110c, a heat sink 112a, 112b, 112c, a power feeder 114, a filter circuit 116a, 116b, 116c, an air blowing fan 118a, 118b, 118c, and an air guide 120a, 120b, 120c.

The case 102 may protect components in the induction heating device 100. For example, the case 102 may be made of aluminum but not limited. The case 102 may be thermally insulated to prevent heat, generated by the working coil 106a, 106b, 106c, 106d, 106e, from leaking outward.

The cover plate 104 may be coupled to an upper end of the case 102 to shield an inside of the case 102, and an object to be heated (not illustrated, an object to be heated by one or more working coils 106a, 106b, 106c, 106d, 106e) may be placed on an upper surface of the cover plate 104.

An object to be heated such as a cooking vessel may be placed on the upper surface of the cover plate 104, and heat generated by the working coil 106a, 106b, 106c, 106d, 106e may be delivered to the object to be heated through the upper surface of the cover plate104.

The cover plate 104 may be made of glass but not limited.

An input interface 1041 configured to receive an input from a user may be disposed on the upper surface of the cover plate 104. The input interface 1041 may be buried into the upper surface of the cover plate 104 and may display a specific image. The input interface 1041 may receive a touch input from the user, and the induction heating device 100 may be driven based on the received touch input.

Specifically, the input interface 1041 may be a module for inputting a heating intensity or a heating period and the like desired by the user, and may be implemented as a physical button or a touch panel and the like. Additionally, the input interface 1041 may display a driving state of the induction heating device 100.

For example, the input interface 1041 may be a thin film transistor liquid crystal display (TFT LCD) but not limited.

Light display areas 1042a, 1042b, 1042c may be formed on the upper surface of the cover plate 104. Light source units 1043a, 1043b, 1043c may be disposed below the cover plate 104, and light emitted from the light source units 1043a, 1043b, 1043c may be delivered to the user through the light display areas 1042a, 1042b, 1042c.

The working coil 106a, 106b, 106c, 106d, 106e may be a heating unit that heats an object to the heated, and may be disposed in the case 102.

The working coil 106a, 106b, 106c, 106d, 106e may include a wire that is wound multiple times in a ring shape, and may generate an AC magnetic field. Additionally, a mica sheet and a ferrite core may be consecutively disposed on a lower side of the working coil 106a, 106b, 106c, 106d, 106e.

The ferrite core may be fixed to the mica sheet through a sealant, and may diffuse the AC magnetic field generated by the working coil 106a, 106b, 106c, 106d, 106e. The mica sheet may be fixed to the working coil 106a, 106b, 106c, 106d, 106e and the ferrite core through a sealant, and may prevent a direct delivery of the heat, generated by the working coil 106a, 106b, 106c, 106d, 106e, to the ferrite core.

A plurality of working coils 106a, 106b, 106c, 106d, 106e may be provided. The plurality of working coils 106a, 106b, 106c, 106d, 106e may include a first working coil 106a disposed in a central portion of the case 102, a second working coil 106b and a third working coil 106c disposed on a right side of the first working coil 106a, and a fourth working coil 106d and a fifth working coil 106e disposed on a left side of the first working coil 106a. The second working coil 106b and the third working coil 106c may be disposed on the right side of the first working coil 106a in an up-down direction, and the fourth working coil 106d and the fifth working coil 106e may be disposed on the left side of the first working coil 106a in the up-down direction.

For example, the first working coil 106a may be a high-output dual heating coil, and the second working coil 106b, the third working coil 106c, the fourth working coil 106d and the fifth working coil 106e may be a single heating coil. The first working coil 106a as a dual heating coil has a heavy weight, and may have a maximum output of 7000 kW.

The induction heating device 100 according to one embodiment may perform the function of wireless power transmission based on the configurations and features described above.

Technologies for wirelessly supplying power have been developed and have been used for a wide range of electronic devices. A battery of an electronic device, to which the wireless power transmitting technology is applied, can be charged only by being placed on a charge pad without connecting to an additional charge connector. Accordingly, the electronic device, to which the wireless power transmitting technology is applied, requires no cord or no charger, thereby ensuring improved mobility and a reduced size and weight.

The wireless power transmitting technology can be broadly classified as an electromagnetic induction technology using a coil, a resonance technology using resonance, and a radio emission technology for converting electric energy into microwaves and delivering the microwaves, and the like. In the electromagnetic induction technology, power is transmitted using electromagnetic induction between a primary coil (e.g., a working coil) included in an apparatus for wirelessly transmitting power and a secondary coil included in an apparatus for wirelessly receiving power.

The theory of the induction heating technology of the induction heating device 100 is substantially the same as that of the electromagnetic induction-based wireless power transmission technology, in that an object to be heated is heated using electromagnetic induction. Accordingly, the induction heating device 100 according to one embodiment may perform the function of wireless power transmission as well as the function of induction heating.

The base plate 108a, 108b, 108c may be disposed at a middle end of the case 102, and the plurality of working coils 106a, 106b, 106c, 106d, 106e may be disposed in an upper portion of the base plate108a, 108b, 108c. The base plate 108a, 108b, 108c may support the plurality of working coils 106a, 106b, 106c, 106d, 106e that are heavy, and may help the plurality of working coils 106a, 106b, 106c, 106d, 106e to be mounted. The input interface 1041 and the light source units 1043a, 1043b, 1043c may be further disposed in the upper portion of the base plate 108a, 108b, 108c.

According to one embodiment, a plurality of base plates 108a, 108b, 108c may be provided but not limited. Alternatively, a single base plate may be disposed in the case 102.

According to one embodiment, the plurality of base plates 108a, 108b, 108c may include a first base plate 108a, a second base plate 108b, and a third base plate 108c.

The first base plate 108a, the second base plate 108b, and the third base plate 108c may be disposed at the middle end of the case 102 side by side.

The first base plate 108a may be disposed in a central portion of the middle end of the case 102. The first working coil 106a may be disposed in an upper portion of the first base plate 108a.

The input interface 1041, and a first light source unit 1043a corresponding to the first working coil 106a may be further disposed in the upper portion of the first base plate 108a. The first base plate 108a may have a through hole A 1081a for installing the input interface 1041 and the first light source unit 1043a.

The second base plate 108b may be disposed on a right side of the first base plate 108a at the middle end of the case 102. The second working coil 106b and the third working coil 106c may be disposed in an upper portion of the second base plate 108b.

A second light source unit 1043b corresponding to the second working coil 106b and the third working coil 106c may be further disposed in the upper portion of the second base plate 108b. In the upper portion of the second base plate 108b, the second working coil 106b, the third working coil 106c and the second light source unit 1043b may be consecutively disposed. The second base plate 108b may have a through hole B 1081b for installing the second light source unit 1043b.

The third base plate 108c may be disposed on a left side of the first base plate 108a at the middle end of the case 102. The fourth working coil 106d and the fifth working coil 106e may be disposed in an upper portion of the third base plate108c.

A third light source unit 1043c corresponding to the fourth working coil 106d and the fifth working coil 106e may be further disposed in the upper portion of the third base plate108c. In the upper portion of the third base plate108c, the fourth working coil 106d, the fifth working coil 106e and the third light source unit 1043c may be consecutively disposed. The third base plate 108c may have a through hole C 1081c for installing the third light source unit 1043c.

The case 102 may have a plurality of mounting portions 1021 for mounting the plurality of base plates 108a, 108b, 108c at a part of an outer circumferential surface of the case 102. That is, edges of the plurality of base plates 108a, 108b, 108c may be mounted onto a top of the plurality of mounting portions 1021. Accordingly, the plurality of base plates 108a, 108b, 108c may be disposed at the middle end of the case 102.

The case 102 may include a bracket 1022 in a central portion of a lower surface (bottom surface) or of a lower end of the case 102. The bracket 1022 may be disposed in a central portion of a lower side of the first base plate 108a, and may prevent sagging of a lower surface of the first base plate 108a, caused by weight of the first base plate 108a. The weight of the first base plate 108a may include the weight of the first working coil 106a in the upper portion of the first base plate 108a. The second and third base plate 108c and 108b located at the outer sides of the electric range may be supported by the mounting portions 1021 respectively at two edges facing each other as well as along one edge connecting these two edges. However, the first base plate 108a located in the center of the electric range, i.e. between the second and third base plate 108b and 108c, may be supported by the mounting portions 1021 at two edges facing each other, while edges connecting said two edges remain unsupported. For this reason, it is advantageous to provide additional support of the first base plate 108a by means of the bracket 1022.

The bracket 1022 may include at least one elastic element 1025 on a top of the bracket 1022. For example, the elastic element 1025 may be a leaf spring. An upper end of at least one elastic element 1025 may contact the lower surface of the first base plate 108a, and may prevent a sagging of lower surface of the first base plate 108a.

The driving circuit 110a, 110b, 110c may control driving of the plurality of working coils 106a, 106b, 106c, 106d, 106e that are heating units, and may further control driving of components such as an input interface 1041 and the like of the induction heating device 100.

The driving circuit 110a, 110b, 110c may include various components in relation to the driving of the working coils 106a, 106b, 106c, 106d, 106e. The components may include a power supply configured to supply AC power, a rectifier configured to rectify AC power of the power supply into DC power, an inverter configured to convert DC power, rectified by the rectifier, into resonance current as a result of a switching operation and supply the resonance current to the working coil 106, a microcomputer (i.e., a micom) configured to control the inverter and components in relation to driving of the inverter, a relay or a semiconductor switch configured to turn on or turn off the working coils 106a, 106b, 106c, 106d, 106e, and the like. Various types of components may be mounted onto a board of the driving circuit 110a, 110b, 110c.

The driving circuit 110a, 110b, 110c may include a first driving circuit 110a, a second driving circuit 110b, and a third driving circuit 110c. The first driving circuit 110a may be disposed on a right side of the case 102, e.g. on a right side of the lower surface of the case 102, with respect to the bracket 1022 and may control driving of the first working coil 106a. The second driving circuit 110b may be disposed on the right side of the first driving circuit 110a and may control driving of the second working coil 106b and the third working coil 106c. The third driving circuit 110c may be disposed on a left side of the case 102, e.g. on a left side of the lower surface of the case 102, with respect to the bracket 1022 and may control driving of the fourth working coil 106d and the fifth working coil 106e.

The heat sink 112a, 112b, 112c may be disposed over at least a part of the driving circuit 110a, 110b, 110c and may prevent an increase in temperatures of components disposed at at least a part of the driving circuit 110a, 110b, 110c.

The heat sink 112a, 112b, 112c may include a first heat sink 112a, a second heat sink 112b, and a third heat sink 112c. The first heat sink 112a may prevent an increase in temperatures of components installed in at least a part of the first driving circuit 110a, the second heat sink 112b may prevent an increase in temperatures of components installed in at least a part of the second driving circuit 110b, and the third heat sink 112c may prevent an increase in temperatures of components installed in at least a part of the third driving circuit 110c.

The power feeder 114 may supply an external power source to the induction heating device 100. The power feeder 114 may be implemented as a terminal block.

The power feeder 114 may be disposed at any one of edges of the case 102, e.g. at the rear end of the case 102 or on the lower surface of the case 102. For example, the power feeder 114 may be disposed at a rear end of the left side of the lower surface of the case 102.

The filter circuit 116a, 116b, 116c may be disposed at any one of the edges of the lower surface of the case 102, and may reduce noise made by the plurality of working coils 106a, 106b, 106c, 106d, 106e.

The filter circuit 116a, 116b, 116c may include a first filter circuit 116a, a second filter circuit 116b, and a third filter circuit 116c.

The first filter circuit 116a may reduce noise made by the first working coil 106a. The second filter circuit 116b may reduce noise made by the second working coil 106b and the third working coil 106c. The third filter circuit 116c may reduce noise made by the fourth working coil 106d and the fifth working coil 106e.

The air blowing fan 118a, 118b, 118c may reduce a temperature inside the case 102. Accordingly, the air blowing fan 118a, 118b, 118c may lower a temperature of various components installed in the driving circuits 110a, 110b, 110c.

The air blowing fan 118a, 118b, 118c may be disposed below or on the lower side of the working coils 106a, 106b, 106c, 106d, 106e. The air blowing fan 118a, 118b, 118c may be disposed on the lower surface of the case 102, e.g. on a front side or edge thereof.

The air blowing fan 118a, 118b, 118c may include a first air blowing fan 118a, a second air blowing fan 118b, and a third blow fan 118c.

The first air blowing fan 118a may cool various components installed in the first driving circuit 110a and may further cool the first light source unit 1043a and the input interface 1041. Particularly, the first air blowing fan 118a may deliver air (wind) for cooling to the first heat sink 112a over the first driving circuit 110a.

The second air blowing fan 118b may cool various components installed in the second driving circuit 110b and may further cool the second light source unit 1043b. Particularly, the second air blowing fan 118b may deliver air for cooling to the second heat sink 112b over the second driving circuit 110b.

The third air blowing fan 118c may cool various components installed in the third driving circuit 110c and may further cool the third light source unit 1043c. Particularly, the third air blowing fan 118c may deliver air for cooling to the third heat sink 112c over the third driving circuit 110c.

The air blowing fans 118a, 118b, 118c may not include a structure for preventing a foreign substance from contacting the air blowing fans 118a, 118b, 118c.

The air guide 120a, 120b, 120c may guide air generated by the air blowing fans 118a, 118b, 118c. The light source units 1043a, 1043b, 1043c, the input interface 1041, and the air blowing fans 118a, 118b, 118c may be disposed below or on the lower sides of the working coils 106a, 106b, 106c, 106d, 106e. The air guide 120a, 120b, 120c may guide air output from the air blowing fan 118a, 118b, 118c, disposed on the front side of the case 102, toward a rear side of the case 102.

The air guide 120a, 120b, 120c may include a first air guide 120a, a second air guide 120b and a third guide 120c.

The first air guide 120a may be disposed to encircle or surround or cover the first heat sink 112a installed in at least a part of the first driving circuit 110a and may guide (deliver) air, output from the first air blowing fan 118a, to the first heat sink 112a.

The second air guide 120b may be disposed to encircle or surround or cover the second heat sink 112b installed in at least a part of the second driving circuit 110b and may guide air, output from the second air blowing fan 118b, to the second heat sink 112b.

The third air guide 120c may be disposed to encircle or surround or cover the third heat sink 112c installed in at least a part of the third driving circuit 110c and may guide air, output from the third air blowing fan 118c, to the third heat sink 112c.

The induction heating device 100 according to one embodiment may have the configurations and features described above. Below, a shape of the air guide 120a, 120b, 120c and a configuration for preventing air, output from the air blowing fan 118a, 118b, 118c, from escaping out of the air guide 120a, 120b, 120c are specifically described.

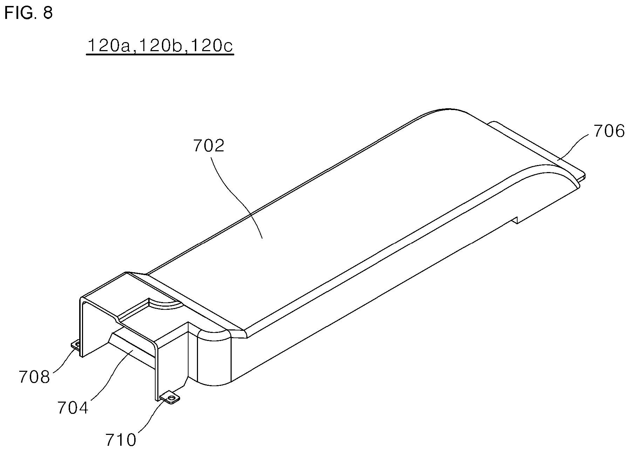

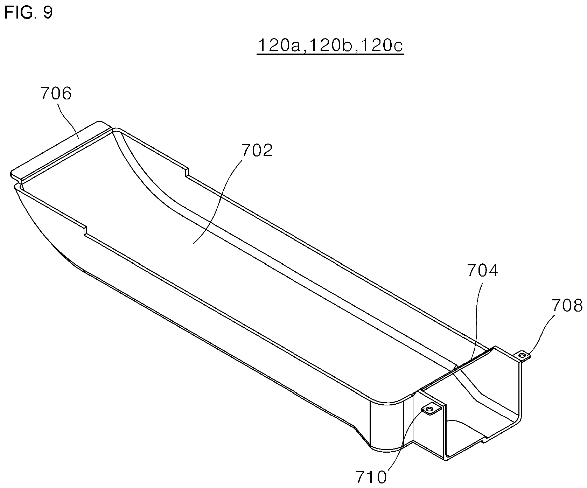

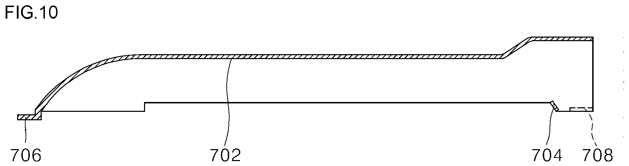

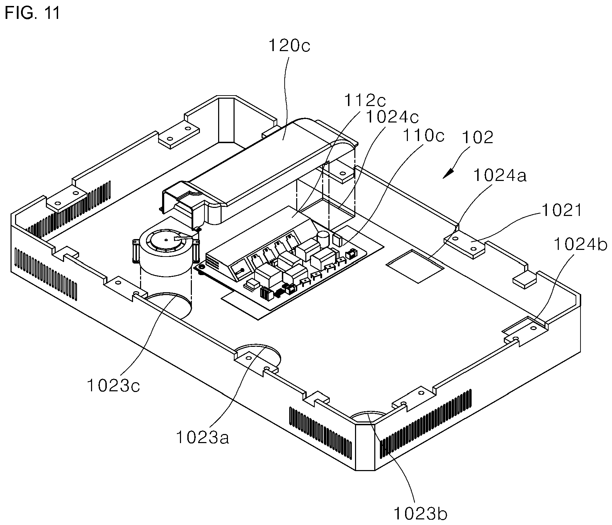

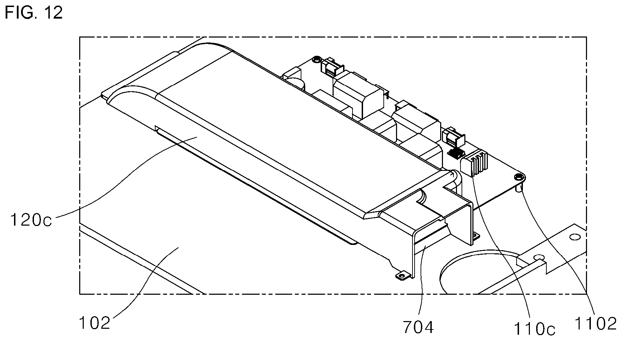

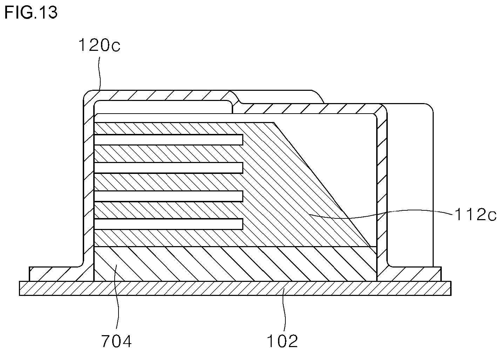

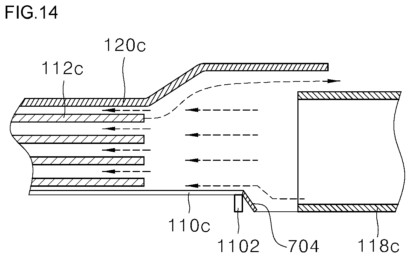

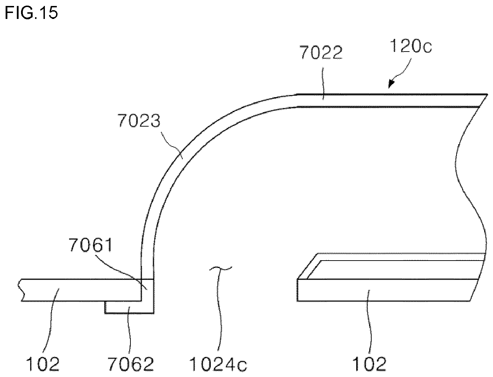

FIG. 8 is a front perspective view showing an air guide 120a, 120b, 120c according to one embodiment. FIG. 9 is a rear perspective view showing an air guide 120a, 120b, 120c according to one embodiment. FIG. 10 is a lateral cross-sectional view showing an air guide 120a, 120b, 120c according to one embodiment. FIG. 11 is a view describing a concept of a shape in which an air blowing fan 118a, 118b, 118c and an air guide 120a, 120b, 120c are disposed in a case 102, according to one embodiment. FIG. 12 is a front perspective view showing a driving circuit 110a, 110b, 110c and an air guide 120a, 120b, 120c disposed in a case 102, according to one embodiment. FIG. 13 is a front cross-sectional view showing an air guide 120a, 120b, 120c disposed in a case 102, according to one embodiment. FIG. 14 is a view describing a concept in which air output from an air blowing fan 118a, 118b, 118c flows into an air guide 120a, 120b, 120c, according to one embodiment. FIG. 15 is a view showing a shape in which the other end of an air guide 120a, 120b, 120c is coupled to a second through hole 1024a, 1024b, 1024c, according to one embodiment.

For convenience of description, FIGS. 11 to 15 show only a way in which the third air guide 120c is disposed over the third driving circuit 110c, in the case 102.

Referring to FIG. 11, a first through hole 1023a, 1023b, 1023c and a second through hole 1024a, 1024b, 1024c may be formed at the lower surface of the case 102. The case 102 may have a shape in which the lower surface of the case 102 is closed except for the first through hole 1023a, 1023b, 1023c and the second through hole 1024a, 1024b, 1024c. The first through hole 1023a, 1023b, 1023c and the second through hole 1024a, 1024b, 1024c may be disposed to face each other. Additionally, the driving circuit 110a, 110b, 110c may be disposed between the first through hole 1023a, 1023b, 1023c and the second through hole 1024a, 1024b, 1024c.

The first through hole 1023a, 1023b, 1023c may serve as a passage through which air is supplied to the air blowing fan 118a, 118b, 118c. The air blowing fan 118a, 118b, 118c may be disposed in the case (102) in order to suck air through the first through hole 1023a, 1023b, 1023c. That is, the first through hole 1023a, 1023b, 1023c may correspond to an air inlet.

The first through hole 1023a, 1023b, 1023c may be formed on the lower surface or end of the case 102 adjacent to the air blowing fans 118a, 118b, 118c, e.g. near lower ends of the air blowing fans 118a, 118b, 118c. Accordingly, air may be supplied to the air blowing fans 118a, 118b, 118c.

The first through hole 1023a, 1023b, 1023c may be formed at an edge of the lower surface of the case 102, e.g. at a front edge or side. The number of the first through holes 1023a, 1023b, 1023c may be the same as that of the air blowing fans 118a, 118b, 118c. That is, a (1-1)th through hole 1023a may provide a passage through which air is supplied to the first air blowing fan 118a, a (1-2)th through hole 1023b may provide a passage through which air is supplied to the second air blowing fan 118b, and a (1-3)th through hole 1023c may provide a passage through which air is supplied to the third air blowing fan 118c. The (1-1)th through hole 1023a, (1-2)th through hole 1023b, and (1-3)th through hole 1023c may be disposed side by side at the edge of the lower surface.

The first through hole 1023a, 1023b, 1023c may have a shape corresponding to a shape of a lower surface, or a suction side, of the air blowing fan 118a, 118b, 118c. That is, the shape of the first through hole 1023a, 1023b, 1023c may be the same as a shape of a fan in the air blowing fan 118a, 118b, 118c but not limited.

The second through hole 1024a, 1024b, 1024c may serve as a passage through which air output from the air blowing fans 118a, 118b, 118c is discharged out of the case 102. That is, the second through hole 1024a, 1024b, 1024c may correspond to an air outlet that discharges air in the case 102 outward.

The air guide 120a, 120b, 120c configured to guide air generated by the air blowing fans 118a, 118b, 118c may be disposed at the lower end of the case 102. One end of the air guide 120a, 120b, 120c may be disposed near or adjacent to the air blowing fan 118a, 118b, 118c. The other end of the air guide 120a, 120b, 120c may contact and connect to the lower surface of the case 102. That is, the other end of the air guide 120a, 120b, 120c may be coupled to the case adjacent to the second through hole 1024a, 1024b, 1024c formed therein.

The second through hole 1024a, 1024b, 1024c may be formed at an edge of the lower surface of the case 102, e.g. at a rear edge or side. The second through hole 1024a, 1024b, 1024c may be connected to the other end of the air guide 120a, 120b, 120c, and accordingly, air may be discharged out of the case 102.

A lower portion of the second through hole 1024a, 1024b, 1024c may have a shape corresponding to a shape of the other end of the air guide 120a, 120b, 120c. That is, the shape of the lower portion of the second through hole 1024a, 1024b, 1024c may be the same as that of the other end of the air guide 120a, 120b, 120c.

The number of the second through holes 1024a, 1024b, 1024c may be the same as that of the air guides 120a, 120b, 120c. A (2-1)th through hole 1024a may connect to the first air guide 120a and provide a passage through which air is discharged, a (2-2)th through hole 1024b may connect to the second air guide 120b and provide a passage through which air is discharged, and a (2-3)th through hole 1024c may connect to the third air guide 120a and provide a passage through which air is discharged. The (2-1)th through hole 1024a, (2-2)th through hole 1024b and (2-3)th through hole 1024c may be disposed side by side at the edge of the upper side of the case 102.

Referring to FIG. 5 and FIGS. 8 to 10, the air guide 120a, 120b, 120c may include a housing 702, a first member 704, a first connecting portion 706, a second connecting portion 708 and a third connecting portion 710. The air guide 120a, 120b, 120c may be integrally formed through single processing.

The housing 702 may constitute a body of the air guide 120a, 120b, 120c. The housing 702 may have a hollow inside. Additionally, the housing 702 may be made of a plastic material but not limited.

The housing 702 may have one end, a middle end and the other end.

One end of the housing 702 may be disposed adjacent to or near the air blowing fan 118a, 118b, 118c. Air output from the air blowing fan 118a, 118b, 118c may be supplied to one end of the housing 702. For example, a part of one end of the housing 702 may be disposed to overlap a part of an output end of the air blowing fan 118a, 118b, 118c.

Referring to FIG. 10, one end of the housing 702 may have a rectangular shape in the lateral cross-sectional view.

A height of at least a part of an upper surface of one end of the housing 702 may be greater than a height of the air blowing fan 118a, 118b, 118c.

Specifically, the upper surface of one end of the housing 702 may include a first portion and a second portion. The first portion and the second portion of one end of the housing 702 may connect to each other. For example, the first portion of one end of the housing 702 may be a right portion of the upper surface of one end of the housing 702, and the second portion of one end of the housing 702 may be a left portion of the upper surface of one end of the housing 702.

The first portion (the right portion) of one end of the housing 702 may be disposed in contact with an upper surface of the air blowing fan 118a, 118b, 118c. That is, the first portion of one end of the housing 702 may be mounted onto the upper surface of the air blowing fan 118a, 118b, 118c.

A height of the second portion (the left portion) of one end of the housing 702 may be greater than a height of the upper surface of the air blowing fan 118a, 118b, 118c. In this case, a gap may be formed between the second portion of one end of the housing 702 and the upper surface of the air blowing fan 118a, 118b, 118c. Through the gap, some of the air output from the air blowing fan 118a, 118b, 118c may be discharged. The discharged air may be delivered to the light source unit 1043a, 1043b, 1043c and the input interface 1041, and based on the discharged air, the light source unit 1043a, 1043b, 1043c and the input interface 1041 may be cooled.

The first member 704 may be formed on a lower side of one end of the housing 702. The first member 704 may be disposed between the air blowing fan 118a, 118b, 118c and the driving circuit 110a, 110b, 110c. One end of the first member 704 may be disposed to contact the lower surface of the case 102, and the other end of the first member 704 may be disposed to contact an end of the driving circuit 110a, 110b, 110c, at which the air blowing fan 118a, 118b, 118c is disposed. A left end of the first member 704 may connect to a left surface of one end of the air guide 120a, 120b, 120c, and a right end of the first member 704 may connect to a right surface of one end of the air guide 120a, 120b, 120c.

The first member 704 may prevent the air, output from the air blowing fan 118a, 118b, 118c, from flowing into a space between the lower surface of the case 102 and the driving circuit 110a, 110b, 110c.

Additionally, the first member 704 may be formed at a slant. In this case, a height of the first member 704 formed at a slant may correspond to a first distance between the air blowing fan 118a, 118b, 118c and the driving circuit 110a, 110b, 110c. Accordingly, the air output from the air blowing fan 118a, 118b, 118c may be guided to the driving circuit 118a, 118b, 118c in a concentrated manner. The first member is specifically described hereunder.

The middle end of the housing 702 may be disposed in a way that encircles at least a part of the driving circuit 118a, 118b, 118c. That is, the heat sink 112a, 112b, 112c may be disposed over at least a part of the driving circuit 118a, 118b, 118c, and may be disposed inside the middle end of the housing 702. Both sides of the middle end of the housing 702 may be disposed in contact with an upper surface of the driving circuit 118a, 118b, 118c, i.e., an upper surface of the board of the driving circuit 118a, 118b, 118c. Particularly, air may be prevented from leaking outward from between a middle end of the air guide 120a, 120b, 120c and the upper surface of the board. Accordingly, based on air flowing to the middle end of the housing 702, the heat sink 112a, 112b, 112c may be efficiently cooled.

Referring to FIG. 10, a first portion at one end of the middle end of the housing 702 may have a pentagonal shape, and the remaining portion of the middle end of the housing 702 may have rectangular shape, in the lateral cross-sectional view. One end of the first portion of the middle end of the housing 702 may connect to one end of the housing 702, and the other end of the first portion of the middle end of the housing 702 may connect to the remaining portion of the middle end of the housing 702.

The other end of the housing 702 may be disposed in contact with the lower surface of the case 102. That is, the other end of the housing 702 may connect to the second through hole 1024a, 1024b, 1024c. Air, output from the air blowing fan 118a, 118b, 118c and passing through at least a part of the driving circuit 118a, 118b, 118c, may be output from the other end of the housing 702.

Referring to FIG. 15, the middle end 7022 of the housing 702 may have a flat shape, and the other end 7023 of the housing 702 connecting to the middle end 7022 of the housing 702 may have a curved shape, in the lateral cross-sectional view. For example, the other end 7023 of the housing 702 may have a circular sector shape having a central angle of 90°. As the other end 7023 of the housing 702 has a curved shape, air in the housing 702 may be smoothly discharged through the second through hole 1024a, 1024b, 1024c.

Particularly, the housing 702 may have the first connecting portion 706 for a connection with the lower surface of the case 102, i.e., the second through hole 1024a, 1024b, 1024c, at the other end thereof.

Referring to FIG. 15, the first connecting portion 706 may include an extended portion 7061 extended downward from the other end of the air guide 120a, 120b, 120c, and a bent portion 7062 bent at the extended portion 7061.

The other end of the second through hole 1024a, 1024b, 1024c and the air guide 120a, 120b, 120c may have a square shape. The extended portion 7061 and the bent portion 7062 may also have a square shape. However, the extended portion 7061 and the bent portion 7062 may have different shapes other than the square shape.

The extended portion 7061 may be disposed to face (in contact with) an upper edge of the second through hole 1024a, 1024b, 1024c, and the bent portion 7062 may be disposed under the lower surface of the case 102 adjacent to the upper edge of the second through hole 1024a, 1024b, 1024c. The first connecting portion 706 may be fitted to an outside of the second through hole 1024a, 1024b, 1024c by an external force applied by a user. Accordingly, the first connecting portion 706 may protrude outward.

That is, the first connecting portion 706 may protrude to an outside of the second through hole 1024a, 1024b, 1024c such that the second through hole 1024a, 1024b, 1024c and the other end of the housing 702 connect. Accordingly, the other end of the housing 702 may be easily connected to the second through hole 1024a, 1024b, 1024c without a means such as a screw-coupling and the like.

The first connecting portion 706 is specifically described hereunder.

Further, the housing 702 may have the second connecting portion 708 and the third connecting portion 710, at one end thereof. The second connecting portion 708 and the third connecting portion 710 may be formed on both sides of one end of the housing 702 and may have a coupling hole for coupling the housing 702 to the lower surface of the case 102. For example, the second connecting portion 708 and the third connecting portion 710 may be screw-coupled to the lower surface of the case 102.

Below, effects of a structure of the air guide 120a, 120b, 120c are specifically described with reference to FIGS. 12 to 15. For convenience of description, FIGS. 12 to 15 show only the third air guide 120c and the third driving circuit 110c.

The driving circuit 110a, 110b, 110c may be spaced a predetermined first distance apart from the lower surface of the case 102 for reasons of insulation and the like. That is, the case 102 may have a boss 1102, protruding upward from the lower surface of the case 102, on the lower surface thereof, and the driving circuit 110a, 110b, 110c may be disposed on the boss 1102.

The air blowing fan 118a, 118b, 118c may be disposed in contact with the lower surface of the case 102. In the related art, air output from the air blowing fan 118a, 118b, 118c may flow to a space between the lower surface of the case 102 and the driving circuit 110a, 110b, 110c. The air flowing to the inbetween space may not be delivered to the heat sink 112a, 112b, 112c. Accordingly, cooling efficiency of the heat sink 112a, 112b, 112c may be reduced.

According to the present disclosure, the first member 704 may be formed at a lower end of one end of the air guide 120a, 120b, 120c, as illustrated in FIGS. 12 to 14. The first member 704 may prevent air, output from the air blowing fan 118a, 118b, 118c, from flowing into the space between the lower surface of the case 102 and the driving circuit 110a, 110b, 110c. Accordingly, the air output from the air blowing fan 118a, 118b, 118c may be prevented from escaping out of the air guide 120a, 120b, 120c.

Additionally, the first member 704 may be formed at a slant at one end of the air guide 120a, 120b, 120c. The inclined shape of the first member 704 may allow the air, output from a lower portion of the air blowing fan 118a, 118b, 118c, to be guided to the driving circuit 110a, 110b, 110c in a concentrated manner.

Based on the first member 704 described above, the induction heating device 100 according to the present disclosure may improve cooling efficiency of the heat sink 112a, 112b, 112c.

The shape of the first member 704 is not limited to the above shape. That is, the first member 704 may have any shape that may prevent air from flowing into the space between the lower surface of the case 102 and the driving circuit 110a, 110b, 110c.

Further, the middle end of the air guide 120a, 120b, 120c may be disposed in a way that encircles at least a part of the driving circuit 110a, 110b, 110c. That is, both sides of the middle end of the air guide 120a, 120b, 120c may be disposed in contact with the upper surface of the driving circuit 110a, 110b, 110c. FIG. 12 shows the disposition specifically.

Referring to FIG. 12, both sides of the middle end of the air guide 120a, 120b, 120c may be disposed in contact with the upper surface of the driving circuit 110a, 110b, 110c. Accordingly, air may be prevented from leaking outward from between the middle end of the air guide 120a, 120b, 120c and the upper surface of the driving circuit 110a, 110b, 110c. Thus, pressure of the air guided by the air guide 120a, 120b, 120c may increase, and cooling efficiency of the heat sink 112a, 112b, 112c may improve.

Further, the air guide 120a, 120b, 120c may have the first connecting portion 706 at an end of the other end thereof. The first connecting portion 706 may protrude to the outside of the second through hole 1024a, 1024b, 1024c such that the second through hole 1024a, 1024b, 1024c and the other end of the air guide 120a, 120b, 120c are connected. Based on the first connecting portion 706, the second through hole 1024a, 1024b, 1024c formed on the lower surface of the case 102 and the other end of the air guide 120a, 120b, 120c may be easily connected.

That is, the air guide 120a, 120b, 120c according to one embodiment may be connected to the lower surface of the case 102 through the first connecting portion 706, the second connecting portion 708 and the third connecting portion 710. Particularly, based on the first connecting portion 706, a connection between the air guide 120a, 120b, 120c and the second through hole 1024a, 1024b, 1024c may be simplified.

In summary, the air guide 120a, 120b, 120c may be manufactured through single processing. Thus, manufacturing costs of the air guide 120a, 120b, 120c may be reduced.

Additionally, the air guide 120a, 120b, 120c may include the first member 704 for preventing leakage of air, at one end thereof, and both sides of the middle end of the air guide 120a, 120b, 120c may be disposed in contact with the upper surface of the driving circuit 110a, 110b, 110c. Thus, air for cooling the heat sink 112a, 112b, 112c may be prevented from leaking outward, and cooling efficiency of the heat sink 112a, 112b, 112c may be improved. Particularly, the first member 704 may be disposed at a slant such that air is delivered to the heat sink 112a, 112b, 112c in a concentrated manner.

Further, the first connecting portion 706 may be formed at the end of the other end of the air guide 120a, 120b, 120c, and based on the first connecting portion 706, the second through hole 1024a, 1024b, 1024c, formed on the lower surface of the case 102, and the other end of the air guide 120a, 120b, 120c may be connected. Thus, air in the air guide 120a, 120b, 120c may be effectively discharged out of the case, and the other end of the air guide 120a, 120b, 120c may be easily connected to the second through hole 1024a, 1024b, 1024c.

## Claims

1. An electric range, comprising:
a case (102) having a first through hole (1023a, 1023b, 1023c) and a second through hole (1024a, 1024b, 1024c);
a heating unit (106a, 106b, 106c, 106d, 106e) disposed in the case (102), and configured to heat an object to be heated;
a driving circuit (110a, 110b, 110c) configured to drive the heating unit (106a, 106b, 106c, 106d, 106e) and disposed between the first through hole (1023a, 1023b, 1023c) and the second through hole (1024a, 1024b, 1024c);
an air blowing fan (118a, 118b, 118c) disposed in the case (102) at the first through hole (1023a, 1023b, 1023c) to introduce air through the first through hole (1023a, 1023b, 1023c) into the case (102); and
an air guide (120a, 120b, 120c) disposed between the air blowing fan (118a, 118b, 118c) and the second through hole (1024a, 1024b, 1024c) and configured to guide air from the air blowing fan (118a, 118b, 118c) to the driving circuit (110a, 110b, 110c) and then to the second through hole (1024a, 1024b, 1024c) to discharge the air therethrough;
wherein an end of the air guide (120a, 120b, 120c) is disposed adjacent to the second through hole (1024a, 1024b, 1024c);
**characterized in that**:
a first connecting portion (706) is formed at the end the air guide (120a, 120b, 120c) adjacent to the second through hole (1024a, 1024b, 1024c), wherein the first connecting portion (706) passes through the second through hole (1024a, 1024b, 1024c) to couple said end of the air guide (120a, 120b, 120c) to the case (102).

2. The electric range of claim 1, wherein the driving circuit (110a, 110b, 110c) is spaced apart from a lower surface of the case (102) by a predetermined first distance, and
wherein one end of the air guide (120a, 120b, 120c) is disposed adjacent to the air blowing fan (118a, 118b, 118c) and has a first member (704) configured to prevent the air output from the air blowing fan (118a, 118b, 118c) from flowing into the space between the lower surface of the case (102) and the driving circuit (110a, 110b, 110c).

3. The electric range of claim 2, wherein the first member (704) is disposed between the air blowing fan (118a, 118b, 118c) and the driving circuit (110a, 110b, 110c).

4. The electric range of claim 2 or 3, wherein the first member (704) is in contact with at least one of the lower surface of the case (102) and the driving circuit (110a, 110b, 110c).

5. The electric range of claim 2, 3 or 4, wherein the first member (704) has an inclined shape configured to guide air output from the air blowing fan (118a, 118b, 118c) to an upper portion of the driving circuit (110a, 110b, 110c).

6. The electric range according to any one of the preceding claims when depending on claim 2, wherein a height of the first member (704) corresponds to the first distance.

7. The electric range according to any one of the preceding claims, wherein the air guide (120a, 120b, 120c) includes a middle portion covering at least a part of the driving circuit (110a, 110b, 110c).

8. The electric range of claim 7, wherein the middle portion of the air guide (120a, 120b, 120c) has a U-shaped cross-section and both sides of the middle portion are disposed in contact with the driving circuit (110a, 110b, 110c).

9. The electric range of claim 7 or 8, further comprising:
a heat sink (112a, 112b, 112c) disposed over at least a part of the driving circuit (110a, 110b, 110c),
wherein the heat sink (112a, 112b, 112c) is disposed inside the middle portion of the air guide (120a, 120b, 120c).

10. The electric range according to any one of the preceding claims, wherein the end of the air guide (120a, 120b, 120c) adjacent to the second through hole (1024a, 1024b, 1024c) at least partially surrounds the second through hole (1024a, 1024b, 1024c).

11. The electric range of claim 10, wherein the end of the air guide (120a, 120b, 120c) adjacent to the second through hole (1024a, 1024b, 1024c) has a curved shape.

12. The electric range according to any one of the preceding claims, wherein the first connecting portion (706) has an extended portion (7061) extending through the second through hole (1024a, 1024b, 1024c) and a bent portion (7062) extending at an angle from the extended portion (7061) in parallel to an outside of the lower surface of the case.

13. The electric range according to any one of the preceding claims, wherein at least one connecting portion (708, 710) is formed extending laterally from the one end of the air guide (120a, 120b, 120c) that is adjacent to the air blowing fan, and
wherein the connection portion (708, 710) has a coupling hole for coupling the air guide (120a, 120b, 120c) to the case (102).

14. The electric range according to any one of the preceding claims, wherein the air guide (120a, 120b, 120c) has an open lower side, and/or
wherein one end of the air guide (120a, 120b, 120c) adjacent to the air blowing fan has an opening extending in a vertical plane, and/or wherein the other end of the air guide (120a, 120b, 120c) adjacent to the second through hole (1024a, 1024b, 1024c) has an opening extending in a horizontal plane.

## Patentansprüche

1. Elektroherd, der Folgendes umfasst:
ein Gehäuse (102), das ein erstes Durchgangsloch (1023a, 1023b, 1023c) und ein zweites Durchgangsloch (1024a, 1024b, 1024c) aufweist;
eine Heizeinheit (106a, 106b, 106c, 106d, 106e), die in dem Gehäuse (102) angeordnet ist und konfiguriert ist, ein zu erhitzendes Objekt zu erhitzen;
eine Ansteuerschaltung (110a, 110b, 110c), die konfiguriert ist, die Heizeinheit (106a, 106b, 106c, 106d, 106e) anzusteuern, und zwischen dem ersten Durchgangsloch (1023a, 1023b, 1023c) und dem zweiten Durchgangsloch (1024a, 1024b, 1024c) angeordnet ist;
ein Luftgebläse (118a, 118b, 118c), das in dem Gehäuse (102) an dem ersten Durchgangsloch (1023a, 1023b, 1023c) angeordnet ist, um Luft durch das erste Durchgangsloch (1023a, 1023b, 1023c) in das Gehäuse (102) einzuleiten; und
eine Luftführung (120a, 120b, 120c), die zwischen dem Luftgebläse (118a, 118b, 118c) und dem zweiten Durchgangsloch (1024a, 1024b, 1024c) angeordnet ist und konfiguriert ist, Luft von dem Luftgebläse (118a, 118b, 118c) zu der Ansteuerschaltung (110a, 110b, 110c) und anschließend zu dem zweiten Durchgangsloch (1024a, 1024b, 1024c) zu führen, um die Luft dadurch auszustoßen;
wobei ein Ende der Luftführung (120a, 120b, 120c) neben dem zweiten Durchgangsloch (1024a, 1024b, 1024c) angeordnet ist;
**dadurch gekennzeichnet, dass**:
ein erster Verbindungsabschnitt (706) an dem Ende der Luftführung (120a, 120b, 120c), das sich neben dem zweiten Durchgangsloch (1024a, 1024b, 1024c) befindet, gebildet ist, wobei der erste Verbindungsabschnitt (706) durch das zweite Durchgangsloch (1024a, 1024b, 1024c) verläuft, um das Ende der Luftführung (120a, 120b, 120c) mit dem Gehäuse (102) zu koppeln.

2. Elektroherd nach Anspruch 1, wobei die Ansteuerschaltung (110a, 110b, 110c) von einer unteren Oberfläche des Gehäuses (102) um einen vorgegebenen ersten Abstand beabstandet ist und
wobei ein Ende der Luftführung (120a, 120b, 120c) neben dem Luftgebläse (118a, 118b, 118c) angeordnet ist und ein erstes Element (704) aufweist, das konfiguriert ist, zu verhindern, dass die Luft, die von dem Luftgebläse (118a, 118b, 118c) ausgegeben wird, in den Raum zwischen der unteren Oberfläche des Gehäuses (102) und der Ansteuerschaltung (110a, 110b, 110c) fließt.

3. Elektroherd nach Anspruch 2, wobei das erste Element (704) zwischen dem Luftgebläse (118a, 118b, 118c) und der Ansteuerschaltung (110a, 110b, 110c) angeordnet ist.

4. Elektroherd nach Anspruch 2 oder 3, wobei sich das erste Element (704) im Kontakt mit der unteren Oberfläche des Gehäuses (102) und/oder der Ansteuerschaltung (110a, 110b, 110c) befindet.

5. Elektroherd nach Anspruch 2, 3 oder 4, wobei das erste Element (704) eine geneigte Form aufweist, die konfiguriert ist, die Luft, die von dem Luftgebläse (118a, 118b, 118c) ausgegeben wird, in einen oberen Abschnitt der Ansteuerschaltung (110a, 110b, 110c) zu führen.

6. Elektroherd nach einem der vorhergehenden Ansprüche, wenn abhängig von Anspruch 2, wobei eine Höhe des ersten Elements (704) der ersten Entfernung entspricht.

7. Elektroherd nach einem der vorhergehenden Ansprüche, wobei die Luftführung (120a, 120b, 120c) einen mittleren Abschnitt enthält, der zumindest einen Teil der Ansteuerschaltung (110a, 110b, 110c) bedeckt.

8. Elektroherd nach Anspruch 7, wobei der mittlere Abschnitt der Luftführung (120a, 120b, 120c) einen U-förmigen Querschnitt aufweist und beide Seiten des mittleren Abschnitts in Kontakt mit der Ansteuerschaltung (110a, 110b, 110c) angeordnet sind.

9. Elektroherd nach Anspruch 7 oder 8, der ferner Folgendes umfasst:
einen Kühlkörper (112a, 112b, 112c), der zumindest über einem Teil der Ansteuerschaltung (110a, 110b, 110c) angeordnet ist,
wobei der Kühlkörper (112a, 112b, 112c) in dem mittleren Abschnitt der Luftführung (120a, 120b, 120c) angeordnet ist.

10. Elektroherd nach einem der vorhergehenden Ansprüche, wobei das Ende der Luftführung (120a, 120b, 120c), das sich neben dem zweiten Durchgangsloch (1024a, 1024b, 1024c) befindet, das zweite Durchgangsloch (1024a, 1024b, 1024c) zumindest teilweise umgibt.

11. Elektroherd nach Anspruch 10, wobei das Ende der Luftführung (120a, 120b, 120c), das sich neben dem zweiten Durchgangsloch (1024a, 1024b, 1024c) befindet, eine gekrümmte Form aufweist.

12. Elektroherd nach einem der vorhergehenden Ansprüche, wobei der erste Verbindungsabschnitt (706) einen verlängerten Abschnitt (7061), der sich durch das zweite Durchgangsloch (1024a, 1024b, 1024c) erstreckt, und einen gebogenen Abschnitt (7062), der sich unter einem Winkel von dem verlängerten Abschnitt (7061) parallel zu einer Außenseite der unteren Oberfläche des Gehäuses erstreckt, aufweist.

13. Elektroherd nach einem der vorhergehenden Ansprüche, wobei mindestens ein Verbindungsabschnitt (708, 710) gebildet ist, der sich von dem einen Ende der Luftführung (120a, 120b, 120c), das sich neben dem Luftgebläse befindet, seitlich erstreckt, und
wobei der Verbindungsabschnitt (708, 710) ein Kopplungsloch zum Koppeln der Luftführung (120a, 120b, 120c) mit dem Gehäuse (102) aufweist.

14. Elektroherd nach einem der vorhergehenden Ansprüche, wobei die Luftführung (120a, 120b, 120c) eine offene untere Seite aufweist und/oder
wobei ein Ende der Luftführung (120a, 120b, 120c), das sich neben dem Luftgebläse befindet, eine Öffnung aufweist, die sich in einer vertikalen Ebene erstreckt, und/oder wobei das andere Ende der Luftführung (120a, 120b, 120c), das sich neben dem zweiten Durchgangsloch (1024a, 1024b, 1024c) befindet, eine Öffnung aufweist, die sich in einer horizontalen Ebene erstreckt.

## Revendications

1. Cuisinière électrique, comportant :
un caisson (102) ayant un premier trou traversant (1023a, 1023b, 1023c) et un second trou traversant (1024a, 1024b, 1024c) ;
une unité de chauffage (106a, 106b, 106c, 106d, 106e) disposée dans le caisson (102), et configurée pour chauffer un objet à chauffer ;
un circuit de commande (110a, 110b, 110c) configuré pour commander l'unité de chauffage (106a, 106b, 106c, 106d, 106e) et disposé entre le premier trou traversant (1023a, 1023b, 1023c) et le second trou traversant (1024a, 1024b, 1024c) ;
un ventilateur de soufflage d'air (118a, 118b, 118c) disposé dans le caisson (102) au niveau du premier trou traversant (1023a, 1023b, 1023c) pour introduire de l'air à travers le premier trou traversant (1023a, 1023b, 1023c) dans le caisson (102) ; et
un guide d'air (120a, 120b, 120c) disposé entre le ventilateur de soufflage d'air (118a, 118b, 118c) et le second trou traversant (1024a, 1024b, 1024c) et configuré pour guider l'air provenant du ventilateur de soufflage d'air (118a, 118b, 118c) jusqu'au circuit de commande (110a, 110b, 110c) et ensuite jusqu'au second trou traversant (1024a, 1024b, 1024c) pour évacuer l'air à travers celui-ci ;
dans laquelle une extrémité du guide d'air (120a, 120b, 120c) est disposée au voisinage du second trou traversant (1024a, 1024b, 1024c) ;
**caractérisée en ce que** :
une première portion de liaison (706) est formée à l'extrémité du guide d'air (120a, 120b, 120c) au voisinage du second trou traversant (1024a, 1024b, 1024c), dans lequel la première portion de liaison (706) passe à travers le second trou traversant (1024a, 1024b, 1024c) pour coupler ladite extrémité du guide d'air (120a, 120b, 120c) au caisson (102).

2. Cuisinière électrique selon la revendication 1, dans laquelle le circuit de commande (110a, 110b, 110c) est espacé d'une surface inférieure du caisson (102) par une première distance prédéterminée, et
dans laquelle une extrémité du guide d'air (120a, 120b, 120c) est disposée au voisinage du ventilateur de soufflage d'air (118a, 118b, 118c) et a un premier élément (704) configuré pour empêcher l'air délivré à la sortie du ventilateur de soufflage d'air (118a, 118b, 118c) de s'écouler dans l'espace entre la surface inférieure du caisson (102) et le circuit de commande (110a, 110b, 110c).

3. Cuisinière électrique selon la revendication 2, dans laquelle le premier élément (704) est disposé entre le ventilateur de soufflage d'air (118a, 118b, 118c) et le circuit de commande (110a, 110b, 110c).

4. Cuisinière électrique selon la revendication 2 ou 3, dans laquelle le premier élément (704) est en contact avec au moins un élément parmi la surface inférieure du caisson (102) et le circuit de commande (110a, 110b, 110c).

5. Cuisinière électrique selon la revendication 2, 3 ou 4, dans laquelle le premier élément (704) a une forme inclinée configurée pour guider de l'air délivré à la sortie du ventilateur de soufflage d'air (118a, 118b, 118c) jusqu'à une portion supérieure du circuit de commande (110a, 110b, 110c).

6. Cuisinière électrique selon l'une quelconque des revendications précédentes lorsque dépendante de la revendication 2, dans laquelle une hauteur du premier élément (704) correspond à la première distance.

7. Cuisinière électrique selon l'une quelconque des revendications précédentes, dans laquelle le guide d'air (120a, 120b, 120c) inclut une portion centrale recouvrant au moins une partie du circuit de commande (110a, 110b, 110c).

8. Cuisinière électrique selon la revendication 7, dans laquelle la portion centrale du guide d'air (120a, 120b, 120c) a une section transversale en forme de U et les deux côtés de la portion centrale sont disposés en contact avec le circuit de commande (110a, 110b, 110c).

9. Cuisinière électrique selon la revendication 7 ou 8, comportant en outre :
un dissipateur de chaleur (112a, 112b, 112c) disposé au-dessus d'au moins une partie du circuit de commande (110a, 110b, 110c),
dans laquelle le dissipateur de chaleur (112a, 112b, 112c) est disposé à l'intérieur de la portion centrale du guide d'air (120a, 120b, 120c).

10. Cuisinière électrique selon l'une quelconque des revendications précédentes, dans laquelle l'extrémité du guide d'air (120a, 120b, 120c) adjacente au second trou traversant (1024a, 1024b, 1024c) entoure au moins partiellement le second trou traversant (1024a, 1024b, 1024c).

11. Cuisinière électrique selon la revendication 10, dans laquelle l'extrémité du guide d'air (120a, 120b, 120c) adjacente au second trou traversant (1024a, 1024b, 1024c) a une forme incurvée.

12. Cuisinière électrique selon l'une quelconque des revendications précédentes, dans laquelle la première portion de liaison (706) a une portion étendue (7061) s'étendant à travers le second trou traversant (1024a, 1024b, 1024c) et une portion pliée (7062) s'étendant à un angle par rapport à la portion étendue (7061) parallèlement à un extérieur de la surface inférieure du caisson.

13. Cuisinière électrique selon l'une quelconque des revendications précédentes, dans laquelle au moins une portion de liaison (708, 710) est formée en s'étendant latéralement à partir de l'extrémité du guide d'air (120a, 120b, 120c) qui est adjacente au ventilateur de soufflage d'air, et
dans laquelle la portion de liaison (708, 710) a un trou de couplage pour coupler le guide d'air (120a, 120b, 120c) au caisson (102).

14. Cuisinière électrique selon l'une quelconque des revendications précédentes, dans laquelle le guide d'air (120a, 120b, 120c) a un côté inférieur ouvert, et/ou
dans laquelle une extrémité du guide d'air (120a, 120b, 120c) adjacente au ventilateur de soufflage d'air a une ouverture s'étendant dans un plan vertical et/ou dans laquelle l'autre extrémité du guide d'air (120a, 120b, 120c) adjacente au second trou traversant (1024a, 1024b, 1024c) a une ouverture s'étendant dans un plan horizontal.
